# EUROPEAN PATENT SPECIFICATION

(11) **EP 2 003 748 B1**
(45) Date of publication and mention of the grant of the patent: **22.12.2010**
(21) Application number: 08010608.1
(22) Date of filing: 11.06.2008
(51) Int. Cl.: H01S 5/022, H01S 5/02

(54) **Laser diode attachment holder**
Halter zur Befestigung von Laserdioden
Porte-accessoire de diode laser

(30) Priority: 12.06.2007 JP 2007155565
(43) Date of publication of application: 17.12.2008
(73) Proprietor: Funai Electric Co., Ltd., Daito-shi, Osaka 574-0013 (JP)
(72) Inventor: Ikeda, Aiichiro, Daito-shi Osaka (JP)
(74) Representative: Grünecker, Kinkeldey, Stockmair & Schwanhäusser Anwaltssozietät

(56) References cited:
- JP-A- 10 092 970
- JP-A- 2004 111 508
- JP-A- 2004 171 627
- US-A- 5 108 955
- US-A- 5 781 351

## Description

The disclosure of Japanese Patent Application No. 2007-155565 is filed on June 12, 2007.

The present invention relates to a laser diode attachment holder according to the preamble of independent claim 1. Further, the present invention relates to a method of attaching a laser diode to a holder according to independent claim 10.

JP-A-2004 111 508 discloses a method of mounting a last diode in an attachment holder whithout the adhesive ejecting needle contacting the last diode.

In the past, a technique is known in which a semiconductor laser element (laser diode) used as a light source of an optical pickup is positioned to be inserted to an attachment hole of a holder portion (laser diode attachment holder) made of an aluminum diecast and then a thermal emissive adhesive is injected into an injection hole of the holder portion so that the semiconductor laser element is attached to the holder portion (for example, see JP 2004-171627A).

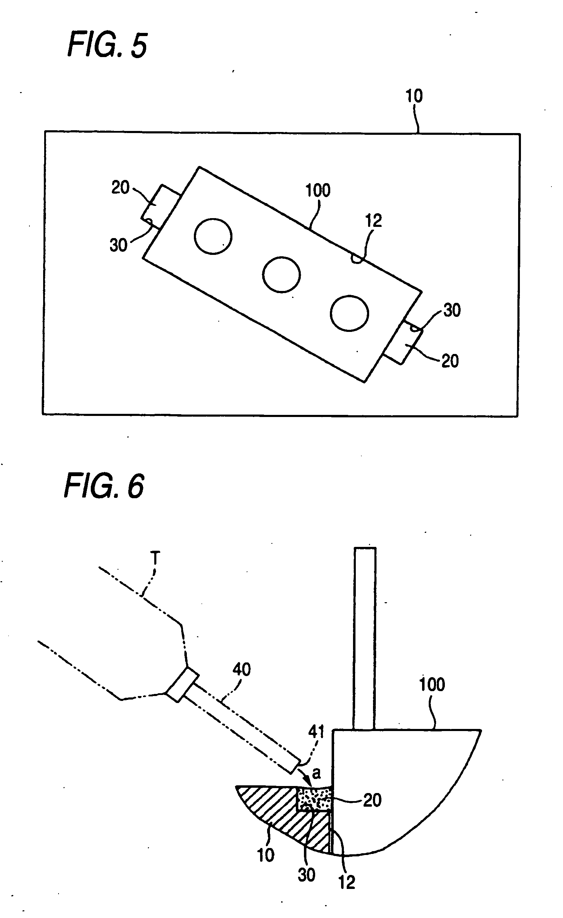

Fig. 5 is a top plan view illustrating a laser diode attachment holder 10 (hereinafter, referred to as 'holder') attached with a laser diode 100 according to a known example. The holder 10 shown in the same drawing is made of metal, and the laser diode 100 which is positioned to be inserted to an attachment hole 12 is bonded to be fixed to the holder 10 by an adhesive 20 which is applied to several points in the vicinity thereof.

Positions in which the adhesive 20 is applied are regulated by concave portions 30 provided in flat outer surfaces of the holder 10, and the adhesive 20 injected into the concave portions 30 is bonded to the wall surfaces of the concave portions 30 or the outer surfaces of the laser diode 100, thereby allowing the laser diode 100 to be bonded and thus fixed to the holder 10 as described above.

Fig. 6 is a sectional view explanatorily illustrating a main part during a process in which the adhesive 20 is injected into the concave portion 30 of the holder 10 (an adhesive injection process). As it may be understood from the same drawing, in the adhesive injection process, a front end 41 of a narrow needle 40 mounted to an adhesive injection jig T is allowed to face the concave portion 30 in an inclined direction from a side position adjacent to the laser diode 100 which is temporarily fixed to an attachment hole 12 of the holder 10. In such a state, a predetermined amount of adhesive ejected from the front end 41 of the needle 40 is injected into the concave portion 30 in the direction indicated by the arrow a.

However, when the adhesive injection process is manually carried out, a problem may arise in that the front end 41 of the needle held in an operator's hand contacts with the laser diode 100 before the adhesive injection process, during the adhesive injection process, or after the adhesive injection process. At this time, when the front end 41 of the needle 40 contacts with the laser diode 100, positional precision of the laser diode 100 which is positioned to be temporarily fixed to the attachment hole 12 of the holder 10 deteriorates. Meanwhile, in an optical pickup, a problem may arise in that recording performance or reproducing performance deteriorates due to a positional deviation of an optic axis of the laser diode 100. For this reason, it is desirable to prevent the above-described case that the front end 41 of the needle 40 contacts with the laser diode 100 to thereby deteriorate positional precision.

It is therefore an object of at least one embodiment of the present invention to provide a laser diode attachment holder that is designed to prevent a case that positional precision of the laser diode deteriorates and to improve workability of an adhesive injection process by regulating a needle which is held in an operator's hand not to contact with a laser diode before the adhesive injection process, during the adhesive injection process, or after the adhesive injection process so that the front end of the needle is prevented from contacting with the laser diode in advance even when the adhesive injection process is manually carried out.

In order to achieve the above objects, a device, in particular a laser diode attachment holder, features the elements of claim 1. There is provided a laser diode attachment holder which comprises an attachment hole taking in a laser diode, a concave portion provided with an adhesive, wherein the laser diode is bonded to the attachment hole through the adhesive, wherein the concave portion is interposed between the attachment hole and a recess, the recess being adapted to fit a needle for ejecting an adhesive through an ejection nozzle, the concave portion and the recess are separated by a step portion to form a passage therebetween, and the step portion serves as a stop for a front end of the adhesive ejecting needle.

With such a configuration, when the adhesive injection process is manually carried out, a position of the needle is regulated so as not to contact with the laser diode just by an operation in which the operator allows the front end of the needle to come into contact with the step portion while holding the jig mounted with the needle in the operator's hand. Then, when the adhesive is ejected from the needle in a state that the front end of the needle comes into contact with the step portion, the adhesive is injected into an application position through the passage of the step portion. After the adhesive injection process, the front end of the needle is made away from the step portion. As a result, according to the invention, it is possible to prevent a case that the front end of the needle contacts with the laser diode before the adhesive injection process, during the adhesive injection process, or after the adhesive injection process to thereby deteriorate positional precision. Also, it is possible to improve workability of the adhesive application process.

A step portion may be formed by a wall portion of a recess to which the needle is fittable. With such a configuration, since the needle is fitted to the recess in a state that the front end comes into contact with the step portion, it is possible to prevent a case that the needle is slid aside thereby interrupt a smooth injection during the adhesive injection process. For this reason, the operator who carries out the adhesive injection process can improve workability and carry out the adhesive injection process with a little skill.

The needle fittable into the recess may be interposed between wall surfaces of the recess so as to be positioned in a diameter direction thereof. With such a configuration, since the needle is fittable into the recess in a state that the front end comes into contact with the step portion, it is possible to improve precision of the adhesive injection process. This effect is more apparently exhibited by adopting a configuration in which a size and a position of the passage is set so that an ejection nozzle of the front end of the needle faces the passage when the needle fitted to the recess is interposable between the wall surfaces of the recess to be positioned in the diameter direction thereof.

A bottom surface of the recess may be downwardly inclined toward the step portion; and the passage may be a groove formed in the step portion. With such a configuration, since the ejection nozzle of the front end of the needle faces the adhesive application position in an inclined direction just by allowing the needle to slide on the inclined surface forming the bottom surface of the recess, it is possible to easily and accurately carry out the adhesive injection process without a skill.

A width of the passage may be narrower than an outer diameter of the front end of the needle. A width of the passage may be substantially equal to an inner diameter of the ejection nozzle of the front end of the needle. An extending direction of the wall portion to which the needle is fittable may be inclined with respect to an extending direction of the recess. Alternatively, an extending direction of the wall portion to which the needle is fittable may be perpendicular to an extending direction of the recess.

Further, in order to achieve the above object, there is provided a method with the elements of claim 10 for attaching a laser diode to a laser diode attachment holder, the laser diode attachment holder comprises an attachment hole to take in a laser diode, a concave portion to be provided with an adhesive, the concave portion is interposed between the attachment hole and a recess, the recess being adapted to fit a needle for ejecting an adhesive through an ejection nozzle, the concave portion and the recess are separated by a step portion to form a passage therebetween, and the step portion serves as a stop for a front end of the adhesive ejecting needle, wherein the needle is inserted into the recess and a front end of the needle is brought into contact with the step portion to eject the adhesive into the concave portion to bond and fix the laser diode to the laser diode attachment holder.

As described above, according to the laser diode attachment holder and the method for attaching the laser diode to the laser diode attachment holder, it is possible to prevent the needle mounted to the jig which is held in an operator's hand can be regulated not to contact with the laser diode before the adhesive injection process, during the adhesive injection process, or after the adhesive injection process even when an adhesive injection process is manually carried out. Thus, the front end of the needle is prevented from contacting with the laser diode in advance, thereby preventing a case that positional precision of the laser diode deteriorates. Accordingly, it is possible to easily and accurately carry out the adhesive injection process. As a result, it is advantageous in that productivity can be improved and deterioration in recording performance or reproducing performance of an optical pickup due to a positional deviation of the optic axis can be prevented, the optical pickup being configured such that the laser diode is attached to the laser diode attachment holder. In addition, the laser diode attachment holder according to the invention can be configured such that a step portion with a recess or a passage is attached to the concave portion of the holder which is described with reference to Fig. 5 and the like. As a result, it is advantageous in that product cost does not increase to prepare additional components.

The above objects and advantages of the present invention will become more apparent by describing in detail exemplary embodiments thereof with reference to the accompanying drawings, wherein:
Fig. 1 is a top view illustrating a holder according to an embodiment of the invention;
Fig. 2 is a top view partly illustrating a state that an adhesive is injected into the holder according to the embodiment;
Fig. 3 is a side view illustrating the state that the adhesive is injected into the holder according to the embodiment;
Fig. 4 is a top view illustrating the holder according to a modified example;
Fig. 5 is a top view illustrating the holder according to a known example;
Fig. 6 is a sectional view illustrating a main part in a state that an adhesive is injected into the holder according to the known example; and
Fig. 7 is a top view illustrating a state that an adhesive is injected into the holder according to another embodiment.

### DETAILED DESCRIPTION OF THE EMBODIMENTS

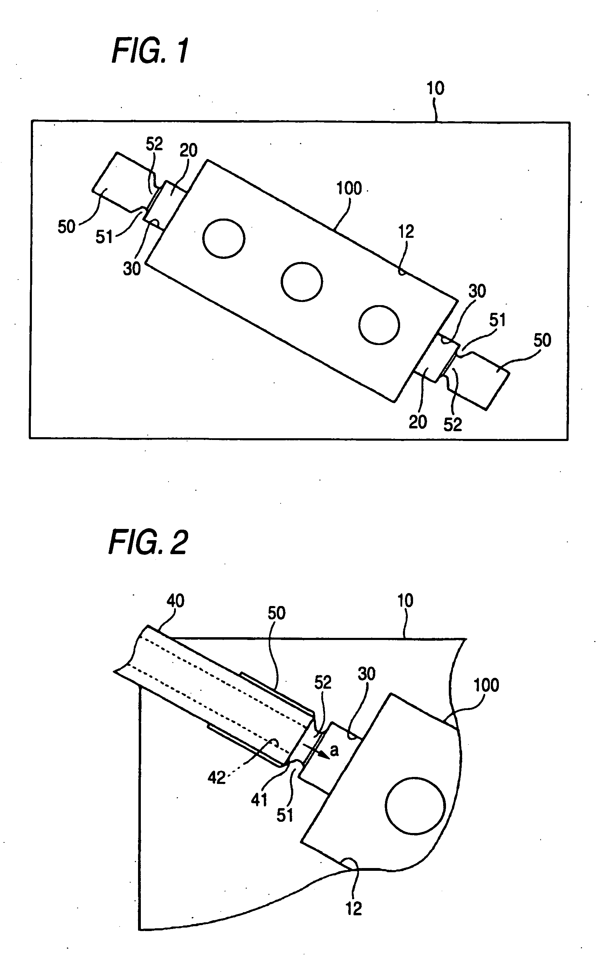

Fig. 1 is a top view illustrating a holder 10 attached with a laser diode 100 according to an embodiment of the invention. In the same drawing, the holder 10 is made of metal, and a laser diode 100 which is positioned to be inserted to an attachment hole 12 is bonded to be fixed to the holder 10 by an adhesive 20 which is applied to several points in the vicinity thereof.

An application position of an adhesive 20 is regulated by each of concave portions 30 which are provided in flat outer surfaces of the holder 10, and then the adhesive 20 which is injected into the concave portions 30 is attached to wall surfaces of the concave portions 30 or the outer surface of the laser diode 100, thereby fixing the laser diode 100 to the holder 10.

As it may be understood from Fig. 1, in this embodiment, each of recesses 50 is formed in the holder 10 on the side opposite to the attachment position of the laser diode 100 with the concave portion 30 interposed therebetween so as to extend in a direction away from the concave portions 30. Then, a wall portion of the recess 50 which separates the recess 50 from the concave portion 30 corresponds to a step portion 51, and a groove-shaped passage 52 is formed in the step portion 51. Accordingly, the recess 50 communicates with the concave portion 30 through the narrow passage 52. In addition, the recess 50 has a width that a needle 40 (which is described below) can be fitted thereto. A groove width of the groove which forms the passage 52 is set to be smaller than an outer diameter of a front end 41 of the needle 40. The width of the passage 52 is set to be substantially the same as a diameter of an ejection nozzle of the front end 41 of the needle 40. Accordingly, the front end of the needle 40 which is inserted to the recess 50 can come into contact with the step portion 51. Further, a total amount of adhesive ejected from the ejection nozzle of the needle 40 is injected into the concave portion 30 through the passage 52.

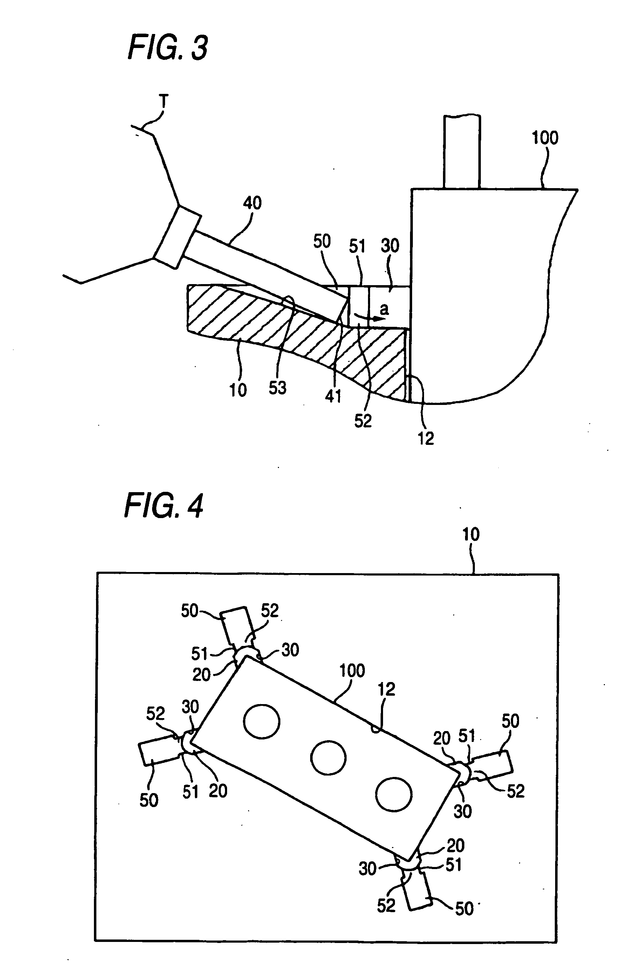

Fig. 2 is a top plan view partly illustrating a state that an adhesive is injected into the laser diode attachment holder 10 with the configuration described with reference to Fig. 1. Fig. 3 is a side view partly illustrating the same state.

As it may be understood from Fig. 2 or 3, in an adhesive injection process, an operator holds an adhesive injection jig T in the operator's hand, and then the operator allows the front end 41 of the narrow needle 40 which is mounted to the jig T to face the concave portion 30 in an inclined direction from a side position adjacent to the laser diode 100 which is positioned to be temporarily fixed to an attachment hole 12 of the holder 10. In such a state, a predetermined amount of adhesive ejected from the front end 41 of the needle 40 is injected into the concave portion 30 in the direction indicated by the arrow a.

In such an adhesive injection process, the front end 41 of the needle 40 faces the concave portion 30 in an inclined direction just by an operation in which the needle 40 of the jig T which is held in the operator's hand is inserted to the recess 50 to allow the front end 41 to come into contact with the step portion 51 before injecting an adhesive. Then, when a predetermined amount of adhesive is ejected from the ejection nozzle 42 of the front end 41 of the needle 40 in a state that the front end 41 of the needle 40 comes into contact with the step portion 51, the adhesive is injected into the concave portion 30 through the groove-shaped passage 52 in the direction indicated by the arrow a. After injecting the adhesive, the front end 41 of the needle 40 becomes away from the step portion 51. Accordingly, in the adhesive injection process, a problem that the needle 40 comes in contact with the laser diode 100 before injecting the adhesive or after injecting the adhesive to thereby deteriorate positional precision of the laser diode 100 does not occur. As a result, although the operator can carries out the adhesive injection process without a skill, the adhesive is easily and accurately injected into the concave portion 30, thereby improving productivity. Additionally, it is possible to prevent deterioration in recording performance or reproducing performance of an optical pickup, which is configured by the laser diode 100 attached to the holder 10, due to a positional deviation of the optic axis.

In the above-described configuration, when the width of the recess 50 is set to be approximately the same as that of the outer diameter of the needle 40, the needle 40 fitted to the recess 50 is inserted to the wall surface of the recess 50 to be positioned thereto in a diameter direction, and thus it is advantageous in that the direction of the needle 40 is easily and accurately set. Additionally, when the size and the position of the passage 52 is set so that the ejection nozzle 42 of the front end 41 of the needle 40 faces the passage 52 in a state that the needle 40 fitted to the recess 50 is interposed between the wall surfaces of the recess 50 to be positioned thereto in the diameter direction, it is possible to more accurately inject the adhesive into the concave portion 30 through the passage 52.

As shown in Fig. 3, in this embodiment, the bottom surface 53 of the recess 50 is formed by an inclined surface which is inclined downward toward the step portion 51. Accordingly, it is advantageous in that the ejection nozzle 42 (see Fig. 2) of the front end 41 of the needle 40 can easily face the concave portion 30 in an inclined direction just by allowing the needle 40 to slide on the bottom surface 53.

In the holder 10 shown in Fig. 1, although the concave portions 30, which correspond to adhesive application positions, are formed in both sides with the laser diode 100 interposed therebetween, the positions where the concave portions 30 are formed may be appropriately modified in consideration of the shape and the size of the laser diode 100. For instance, as shown in Fig. 4, the concave portions 30 are formed as many as the four corners of the angular laser diode 100, the recesses 50 are attached to the concave portions 30, and then the groove-shaped passages 52 are formed in the step portions 51 which are formed by the wall portions of the recesses 50. With this configuration, the laser diode 100 can be more firmly fixed to the holder 10.

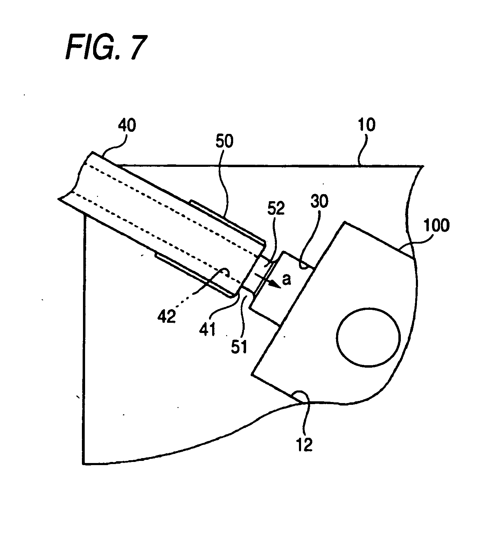

In the above described embodiments, as shown in Fig. 2, an extending direction of the wall portion of the step portion 51 is inclined with respect to an extending direction of the recess 50. This configuration facilitates the injection of the adhesive 20 into the concave portion 30 through the passage 52. However, the extending direction of the wall portion of the step portion 51 may be perpendicular to the extending direction of the recess 50 as shown in Fig. 7. With this configuration, since the front end of the needle 40 which is inserted to the recess 50 can come into close contact with the wall portion of the step portion 51. Therefore, the adhesive is prevented from remaining in a space formed between the front end of the needle 40 and the wall portion of the step portion 51.

Additionally, in Figs. 1 to 6, the same reference numerals are given to the same components or the corresponding components.

## Claims

1. A laser diode attachment holder which comprises:
an attachment hole (12) taking in a laser diode,
a concave portion (30) provided with an adhesive (20), wherein
the laser diode (10) is bonded to the attachment hole through the adhesive (20),
**characterized in that**
the concave portion (30) is interposed between the attachment hole (12) and a recess (50),
the recess (50) being adapted to fit a needle (40) for ejecting an adhesive (20) through an ejection nozzle (42),
the concave portion (30) and the recess (50) are separated by a step portion (51) to form a passage (52) therebetween, and
the step portion (51) serves as a stop for a front end (41) of the adhesive ejecting needle (40).

2. The laser diode attachment holder according to claim 1, wherein the step portion (51) is formed by a wall portion of the recess (50).

3. The laser diode attachment holder according to claim 2, wherein the needle (40) fittable into the recess (50) is interposable between wall surfaces of the recess (50) so as to be positionable co-directionally with said recess (50).

4. The laser diode attachment holder according to claim 3, wherein a size and a position of the passage (52) is set so that the ejection nozzle (42) of the front end (41) of the needle (40) faces the passages (52) when the needle fittable into the recess (50) is interposed between the wall surfaces of the recess (50).

5. The laser diode attachment holder according to claim 4, wherein a bottom surface (53) of the recess (50) is downwardly inclined toward the step portion (51); and wherein the passage (52) is a groove formed in the step portion (51).

6. The laser diode attachment holder according to claim 5, wherein a width of the passage (52) is narrower than an outer diameter of the front end (41) of the needle (40).

7. The laser diode attachment holder according to claim 5, wherein a width of the passage (52) is substantially equal to an inner diameter of the ejection nozzle (42) of the front end (41) of the needle (40).

8. The laser diode attachment holder according to claim 2, wherein an extending direction of the wall portion of the step portion (51) is inclined with respect to an extending direction of the recess (50).

9. The laser diode attachment holder according to claim 2, wherein an extending direction of the wall portion of the step portion (51) is perpendicular to an extending direction of the recess (50).

10. A method for attaching a laser diode (100) to a laser diode attachment holder (10), the laser diode attachment holder (10) comprises
an attachment hole (12) to take in a laser diode,
a concave portion (30) to be provided with an adhesive (20),
the concave portion (30) is interposed between the attachment hole (12) and a recess (50),
the recess (50) being adapted to fit a needle (40) for ejecting an adhesive (20) through an ejection nozzle (42),
the concave portion (30) and the recess (50) are separated by a step portion (51) to form a passage (52) therebetween, and
the step portion (51) serves as a stop for a front end (41) of the adhesive ejecting needle (40), wherein
the needle (40) is inserted into the recess (50) and a front end (41) of the needle (40) is brought into contact with the step portion to eject the adhesive (20) into the concave portion (30) to bond and fix the laser diode (10) to the laser diode attachment holder (10).

## Patentansprüche

1. Ein Laserdiodenhalterung aufweisend ein Befestigungsloch (12) zur Aufnahme der Laserdiode, einen konkaven Abschnitt (30), der mit einem Klebemittel (20) versehen ist, wobei die Laserdiode (10) durch das Klebemittel (20) mit dem Befestigungsloch (12) verbunden ist, **dadurch gekennzeichnet, dass** der konkave Abschnitt (30) zwischen dem Befestigungsloch (12) und einer Ausnehmung (50) angeordnet ist, wobei die Ausnehmung (50) zur Aufnahme einer Nadel (40) geeignet ist zum Einspritzen des Klebemittels (20) durch eine Nadelöffnung (42), wobei der konkave Abschnitt (30) und die Ausnehmung (50) durch einen Vorsprung (51) von einander getrennt sind, der einen Durchgang (52) dazwischen bildet, und wobei der Vorsprung (51) als Stoppmittel für ein vorderes Ende (41) der das Klebmittel emittierenden Nadel (40) dient.

2. Die Laserdiodenhalterung nach Anspruch 1, wobei der Vorsprung (51) durch einen Wandabschnitt der Ausnehmung (50) gebildet ist.

3. Die Laserdiodenhalterung nach Anspruch 2, wobei die Nadel (40), die in die Ausnehmung (50) paßt, zwischen Wandoberflächen der Ausnehmung (50) derart einführbar ist, dass sie zur Erstreckung der Ausnehmung (50) anordenbar ist.

4. Die Laserdiodenhalterung nach Anspruch 3, wobei eine Größe und eine Position des Durchgangs (52) derart geformt ist, dass die Nadelöffnung (42) dem Durchgang (52) gegenüberliegt, wenn die Nadel, die in die Ausnehmung (50) passt, zwischen den Wandoberflächen der Ausnehmung (50) angeordnet ist.

5. Die Laserdiodenhalterung nach Anspruch 4, wobei eine Grundfläche (53) des Ausnehmung (50) schräg nach unten verläuft, in Richtung des Vorsprungs (51), und wobei der Durchgang (52) eine Rinne ist, die in dem Vorsprung (51) gebildet ist.

6. Die Laserdiodenhalterung nach Anspruch 5, wobei eine Weite des Durchgangs (52) schmaler als ein äußerer Durchmesser des vorderen Endes (41) der Nadel ist.

7. Die Laserdiodenhalterung nach Anspruch 5, wobei eine Weite des Durchgangs (52) im wesentlich gleich eines inneren Durchmessers der Nadelöffnung (42) des vorderen Endes (41) der Nadel (40) ist.

8. Die Laserdiodenhalterung nach Anspruch 2, wobei eine Erstreckungsrichtung des Wandabschnittes des Vorsprungs (51) schräg zu einer Erstreckungsrichtung der Ausnehmung (50) gerichtet ist.

9. Die Laserdiodenhalterung nach Anspruch 2, wobei eine Erstreckungsrichtung des Wandabschnittes des Vorsprungs (51) senkrecht zu einer Erstreckungsrichtung der Ausnehmung (50) gerichtet ist.

10. Ein Verfahren zum Anbringen einer Laserdiode (100) an eine Laserdiodenhalterung (10), wobei die Laserdiodenhalterung aufweist, ein Befestigungsloch (12) zur Aufnahme der Laserdiode, einen konkaven Abschnitt (30), der mit einem Klebemittel (20) versehen wird, wobei der konkave Abschnitt (30) zwischen dem Befestigungsloch (12) und einer Ausnehmung (50) angeordnet ist, wobei die Ausnehmung (50) zur Aufnahme einer Nadel (40) geeignet ist zum Einspritzen des Klebmittels (20) durch eine Nadelöffnung (42), wobei der konkave Abschnitt (30) und die Ausnehmung (50) durch einen Vorsprung (51) von einander getrennt sind, der einen Durchgang (52) dazwischen bildet, und wobei der Vorsprung (51) als Stoppmittel für ein vorderes Ende (41) der das Klebmittel emittierenden Nadel (40) dient, wobei die Nadel in die Ausnehmung (50) gesteckt wird und ein vorderes Ende (41) der Nadel (40) in Kontakt mit dem Vorsprung (52) gebracht wird, um das Klebemittel (20) in den konkaven Abschnitt zu spritzen, um die Laserdiode an die Laserdiodenhalterung zu kleben und zu fixieren.

## Revendications

1. Support de fixation de diode laser qui comprend :
un trou de fixation (12) accueillant une diode laser,
une partie concave (30) pourvue d'un adhésif (20), dans lequel la diode laser (10) est collée au trou de fixation par l'adhésif (20), **caractérisé en ce que**
la partie concave (30) est intercalée entre le trou de fixation (12) et un évidement (50),
l'évidement (50) étant adapté pour y ajuster une aiguille (40) pour éjecter un adhésif (20) à travers une buse d'éjection (42),
la partie concave (30) et l'évidement (50) sont séparés par une partie étagée (51) pour former un passage (52) entre eux, et
la partie étagée (51) sert d'arrêt pour une extrémité avant (41) de l'aiguille d'éjection d'adhésif (40).

2. Support de fixation de diode laser selon la revendication 1, dans lequel la partie étagée (51) est formée par une partie de paroi de l'évidement (50).

3. Support de fixation de diode laser selon la revendication 2, dans lequel l'aiguille (40) pouvant être ajustée dans l'évidement (50) peut être intercalée entre les surfaces de paroi de l'évidement (50) de façon à pouvoir être positionnée dans la même direction que ledit évidement (50).

4. Support de fixation de diode laser selon la revendication 3, dans lequel une taille et une position du passage (52) sont réglées de telle manière que la buse d'éjection (42) de l'extrémité avant (41) de l'aiguille (40) fait face aux passage (52) quand l'aiguille pouvant être ajustée dans l'évidement (50) est intercalée entre les surfaces de paroi de l'évidement (50).

5. Support de fixation de diode laser selon la revendication 4, dans lequel une surface inférieure (53) de l'évidement (50) est inclinée vers le bas vers la partie étagée (51) ; et dans lequel le passage (52) est une rainure formée dans la partie étagée (51).

6. Support de fixation de diode laser selon la revendication 5, dans lequel une largeur du passage (52) est plus étroite qu'un diamètre extérieur de l'extrémité avant (41) de l'aiguille (40).

7. Support de fixation de diode laser selon la revendication 5, dans lequel une largeur du passage (52) est sensiblement égale à un diamètre intérieur de la buse d'éjection (42) de l'extrémité avant (41) de l'aiguille (40).

8. Support de fixation de diode laser selon la revendication 2, dans lequel une direction d'extension de la partie de paroi de la partie étagée (51) est inclinée par rapport à une direction d'extension de l'évidement (50).

9. Support de fixation de diode laser selon la revendication 2, dans lequel une direction d'extension de la partie de paroi de la partie étagée (51) est perpendiculaire à une direction d'extension de l'évidement (50).

10. Procédé de fixation d'une diode laser (100) sur un support de fixation de diode laser (10), le support de fixation de diode laser (10) comprend
un trou de fixation (12) pour accueillir une diode laser,
une partie concave (30) destinée à être pourvue d'un adhésif (20),
la partie concave (30) est intercalée entre le trou de fixation (12) et un évidement (50),
l'évidement (50) étant adapté pour y ajuster une aiguille (40) pour éjecter un adhésif (20) à travers une buse d'éjection (42),
la partie concave (30) et l'évidement (50) sont séparés par une partie étagée (51) pour former un passage (52) entre eux, et
la partie étagée (51) sert d'arrêt pour une extrémité avant (41) de l'aiguille d'éjection d'adhésif (40), dans lequel
l'aiguille (40) est insérée dans l'évidement (50) et une extrémité avant (41) de l'aiguille (40) est amenée en contact avec la partie étagée pour éjecter l'adhésif (20) dans la partie concave (30) pour coller et fixer la diode laser (10) sur le support de fixation de diode laser (10).
